# EUROPÄISCHE PATENTANMELDUNG

(11) **EP 1 308 788 A2**
(43) Veröffentlichungstag der Anmeldung: **07.05.2003**
(21) Anmeldenummer: 02023773.1
(22) Anmeldetag: 25.10.2002
(51) Int. Cl.: G03F 9/00

(54) **Vorrichtung zum Ausrichten von Masken in der Fotolithographie**

(30) Priorität: 02.11.2001 DE 10153851
(71) Anmelder: Süss MicroTec Lithography GmbH, 85748 Garching (DE)
(72) Erfinder: Maier, Nikolaus, 85748 Garching (DE); Süss, Ralf, Dr. Ing., 81925 München (DE); Buttinger, Richard, 84034 Landshut (DE)
(74) Vertreter: VOSSIUS & PARTNER

(57) **Zusammenfassung**

Es wird eine Vorrichtung (1) zum Ausrichten von Masken in der Fotolithographie zur Verfügung gestellt, wobei in einem ersten Maskenhalter (2a) für eine erste Maske mindestens ein Adapter (2b) für eine zweite Maske (3b) anordenbar ist, so dass entweder an den ersten Maskenhalter oder an den mindestens einen Adapter angepasste Masken in der Vorrichtung verwendbar sind. Die Vorteile der Erfindung liegen in einem einfachen zeitsparenden und kostengünstigen Übergang von einer Maskengröße auf mindestens eine andere Maskengröße.

## Beschreibung

Die Erfindung betrifft eine Vorrichtung zum Ausrichten von Masken in der Fotolithographie. Die erfindungsgemäße Vorrichtung eignet sich zum schnellen Übergang auf unterschiedliche Maskengrößen bei einer automatischen Zuführung von Masken.

In der Fotolithographie werden Masken bei der Belichtung von Fotolack bei der Strukturierung von Substrat (Wafer)-Oberflächen verwendet. Eine solche Maske ist zum Beispiel in der DE 198 10 055 A1 gezeigt. Bei der industriellen Herstellung von z. B. elektrischen Bauelementen ist es oftmals erforderlich, unterschiedliche Wafergrößen zu verwenden. Das Wechseln der Wafergröße ist auch mit dem Wechseln der Maskengröße verbunden. Bisher ist es üblich, für eine andere Maskengröße auch eine andere Maskenhalterung zu verwenden und entsprechend andere Magazine für die anderen Masken zu verwenden. Das Austauschen der Maskenhalterungen und Magazine ist zeitaufwendig und mit erhöhten Kosten verbunden.

Der Erfindung liegt die Aufgabe zugrunde, eine kostengünstige Vorrichtung zum Ausrichten von Masken in der Fotolithographie zur Verfügung zu stellen, die einen einfachen und schnellen Übergang von einer Maskengröße zu mindestens einer anderen gewährleistet.

Die Aufgabe wird mit den Merkmalen der Patentansprüche gelöst.

Bei der Lösung geht die Erfindung von folgenden Grundgedanken aus.

Ein für eine bestimmte Maskengröße vorgesehener erster Maskenhalter enthält mindestens einen austauschbaren Adapter, der vorzugsweise konzentrisch in der Lichtdurchlassöffnung des ersten Maskenhalters angeordnet ist. Ohne Adapter kann eine größere Maske gehaltert werden und durch Einsetzen des Adapters ist eine kleinere Maskengröße verwendbar. Die zweite Maske ist in einer Fläche angeordnet, deren Maße der Fläche der ersten Maske entsprechen. Auf diese Weise kann für die zweite Maske der gleiche Rahmen und die gleiche Führung wie für die erste Maske verwendet werden.

Vorteilhafterweise kann die Erfindung bei einer automatischen Maskenzuführung mit den gleichen Maskenmagazinen nach einer einfachen Anpassung einer vorhandenen Vorrichtung zur Ausrichtung von Masken zum Einsatz kommen. Mittels der Erfindung kann der Übergang einer Maskengröße zu mindestens einer anderen einfach, zeitsparend und kostengünstig durchgeführt werden.

Im folgenden wird die Erfindung anhand der Zeichnungen näher erläutert. Es zeigen:
- Fig. 1: eine schematische Darstellung einer erfindungsgemäßen Ausführungsform,
- Fig. 2: einen Adapter für die erfindungsgemäße Ausführungsform gemäß Fig. 1,
- Fig. 3: eine Maske für die erfindungsgemäße Ausführungsform gemäß Fig. 1,
- Fig. 4: die erfindungsgemäße Ausführungsform gemäß Fig. 1 ohne Adapter, und
- Fig. 5: ein Realbild in perspektivischer Ansicht der schematischen Darstellungen gemäß Fig. 1 bis 3.

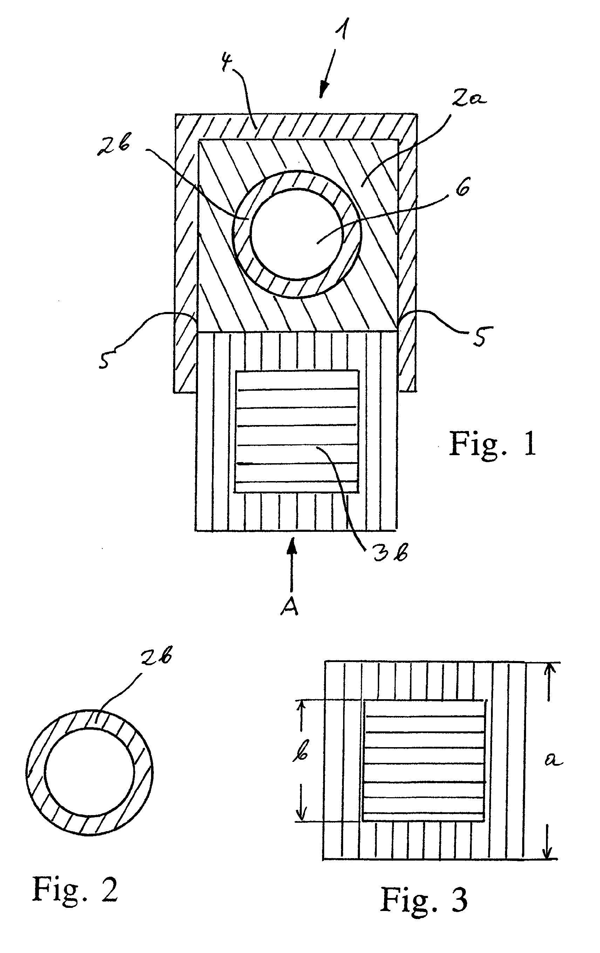

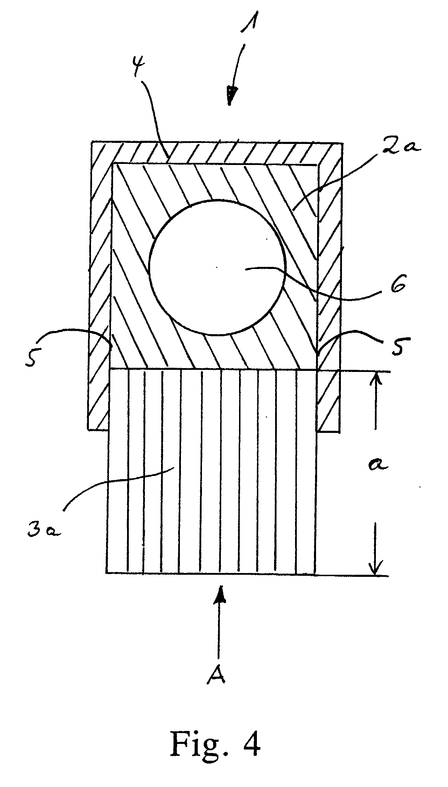

Fig. 1 zeigt schematisch eine erfindungsgemäße Ausführungsform einer Vorrichtung 1 zum Ausrichten von Masken in der Fotolithographie. Ein Maskenhalter 2a ist in einem Rahmen 4 angeordnet. In der Lichtdurchlassöffnung 6 des Maskenhalters 2a ist austauschbar ein Adapter 2b angeordnet, der es ermöglicht, auch eine kleinere Maske als die für den Maskenhalter 2a geeignete zu verwenden. Zum Vergleich wird auf Fig. 4 verwiesen, in der der Maskenhalter 2a ohne Adapter verwendet wird und für eine große Maske 3a vorgesehen ist. In Fig. 1 ist für den Adapter 2b eine entsprechend kleinere Maske 3b vorgesehen. Die Maske 3b ist in einer Fläche angeordnet, die dieselben Seitenmaße (quadratisch mit der Seitenlänge a) wie die Maske 3a aufweist. Das heißt, in der gleichen Vorrichtung 1 mit dem gleichen Rahmen 4 und gleichen Führungsschienen 5 kann mindestens eine weitere Maske 3b verwendet werden. Auf die gleiche Weise läßt sich die Vorrichtung 1 auch an zwei oder mehr weitere Masken anpassen, indem vorzugsweise konzentrisch weitere Adapter in dem Maskenhalter 2a angeordnet sind. Das heißt, diese weitere Masken würden wie die zweite Maske 3b in einer quadratischen Fläche mit der Seitenlänge a angeordnet und somit in die Führungsschienen 5 einführbar sein.

Die Fig. 2 und 3 zeigen isolierte Darstellungen des Adapters 2b und der Maske 3b. Die Maske 3b hat vorzugsweise eine Seitenlänge b von 229 mm (9 Inch) und ermöglicht den Einsatz eines kleineren Wafers in der Vorrichtung 1, deren Maskenhalter 2a vorzugsweise für eine Maske mit der Seitenlänge a von 356 mm (14 Inch) vorgesehen ist.

Die Verwendung der Vorrichtung 1 für die 14 Inch-Maske ist in Fig. 4 dargestellt, wo der Adapter 2b entfernt ist, so dass die Maske 3a verwendet werden kann.

Die Vorrichtung 1 ist für die automatische Zuführung von Masken aus ein und demselben Magazin geeignet. Da die unterschiedlichen Masken jeweils in einer Fläche mit denselben Seitenlängen angeordnet sind, sind sie in dem gleichen Magazin stapelbar und werden auf die gleiche Weise der Vorrichtung 1 zugeführt. Die Masken werden in Richtung des Pfeiles A in den Fig. 1 und 4 über den entsprechenden Maskenhalter 2a bzw. den Adapter 2b in den Führungsschienen 5 geschoben und mit einem unter der Vorrichtung 1 angeordnetem Wafer (nicht dargestellt) ausgerichtet. Nachdem die entsprechenden Masken auf demselben Wege wieder entfernt wurden, können neue Masken entweder derselben Größe oder nach Einsetzen entsprechender Adapter mit kleinerer Größe verwendet werden.

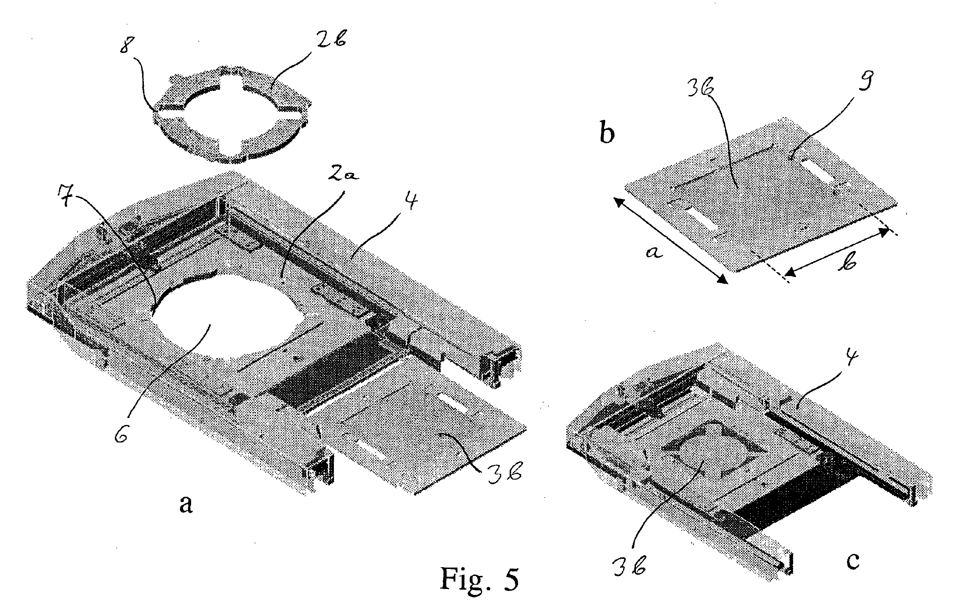

Fig. 5 zeigt in der perspektivischen Darstellung ein Realbild der schematischen Darstellung gemäß Fig. 1 bis 3. Es ist in Fig. 5a zu erkennen, dass der Maskenhalter 2a in der Lichtdurchlassöffnung 6 Aussparungen 7 aufweist, in die entsprechende Vorsprünge 8 des Adapters 2b passen, um den Adapter 2b in dem Maskenhalter 2a auszurichten. Fig. 5b zeigt eine zweite Maske 3b mit der Seitenlänge b in einer Fläche mit der Seitenlänge a, die der Fläche der 14 Inch-Maske 3a entspricht. Die Maske 3b kann durch Stifte an Stellen 9 in der quadratischen Fläche mit der Seitenlänge a austauschbar gehaltert werden. Fig. 5c zeigt die Maske 3b auf dem Adapter 2b, wobei die Strukturen des Adapters durch die Maske 3b hindurch scheinen.

Vorzugsweise ist die Erfindung für die schnelle Auswechslung von 14 Inch-Masken gegen 9 Inch-Masken bei einem automatisierten Herstellungsprozess vorgesehen.

## Patentansprüche

1. Vorrichtung zum Ausrichten von Masken in der Fotolithographie, wobei in einem ersten Maskenhalter (2a) mindestens ein Adapter (2b) für eine zweite Maske (3b) anordenbar ist, um mit dem ersten Maskenhalter (2a) mindestens einen zweiten Maskenhalter auszubilden, so dass entweder an den ersten Maskenhalter (2a) oder an den Adapter (2b) angepasste erste oder zweite Masken (3a bzw. 3b) in der Vorrichtung verwendbar sind.

2. Vorrichtung nach Anspruch 1, wobei der Adapter (2b) konzentrisch in einer Lichtdurchlassöffnung (6) des ersten Maskenhalters (2a) angeordnet ist.

3. Vorrichtung nach Anspruch 1 oder 2, wobei die erste Maske (3a) eine quadratische Fläche mit einer Seitenlänge von 356 mm und die zweite Maske (3b) eine quadratische Fläche mit einer Seitenlänge von 229 mm aufweist.

4. Vorrichtung nach einem der Ansprüche 1 bis 3 mit einem Rahmen (4), an dem der erste Maskenhalter (2a) angeordnet ist, wobei der Rahmen (4) eine Führung (5) aufweist, in der entweder die erste Maske (3a) oder die zweite Maske (3b) zum Ausrichten mit einem Substrat über dem ersten Maskenhalter (2a) oder dem Adapter (2b) bewegbar ist, und wobei die zweite Maske (3b) in einer Fläche mit den Seitenmaßen der ersten Maske (3a) angeordnet ist.

5. Vorrichtung nach einem der Ansprüche 1 bis 4, wobei die erste und die zweite Maske (3a bzw. 3b) aus einem gleichen Maskenmagazin zuführbar sind.

6. Vorrichtung nach einem der Ansprüche 1 bis 5, wobei in dem ersten Maskenhalter (2a) zwei Adapter für zwei Masken anordenbar sind, so dass die Vorrichtung (1) für drei Masken einsetzbar ist.
